# EUROPEAN PATENT APPLICATION

(11) **EP 2 093 519 A2**
(43) Date of publication of application: **26.08.2009**
(21) Application number: 09002380.5
(22) Date of filing: 20.02.2009
(51) Int. Cl.: F24J 2/06, F24J 2/40

(54) **Multiple mechanisms of solar concentration in a photovoltaic plants and/or solar thermal plants**

(30) Priority: 20.02.2008 IT MI20080263
(71) Applicant: Di Donato, Alfonso, 21054 Fagnano Olona (VA) (IT)
(72) Inventor: Di Donato, Alfonso, 21054 Fagnano Olona (VA) (IT)

(57) **Abstract**

The invention wants to use walls which can move by being filled by a gas and/or liquid and/or fixed walls, which change status from transparent to reflective and vice versa, using gasses or liquids reflective or electricity, with the desired effect of creating a higher solar concentration on the photovoltaic and /or solar thermal panels.

## Description

### SUMMARY

This invention wants to improve the performances of the photovoltaic plants and/or solar thermal plants kept in a fixed position, using a type of low cost concentration system.

The invention wants to use walls which can move by being filled by a gas and/or liquid and/or fixed walls, which change status from transparent to reflective and vice versa, using gasses or liquids reflective or electricity, with the desired effect of creating a higher solar concentration on the photovoltaic and /or solar thermal panels

### DESCRIPTION

This invention wants to improve the performance of solar thermal and/or photovoltaic plants using low cost concentration system. It has been noted that, considering the same surface of photovoltaic and/or solar thermal panels installed, the quantity of energy produced is proportional to the solar radiation received. For this reason, the solar concentration has been the object of research and experiment of this patent.

In more detail, if, until today, previous studies focalized only on systems that could obtain a solar concentration for the photovoltaic plants, this research investigated the use of low cost materials that increase the production of photovoltaic plants and solar thermal plants. With this invention the walls move when filled with gas and/or liquid, depending on the position of the sun, they move in steps into a place where they can reflect the suns rays.

As alternative and/or as addition, the same effect of concentration is obtained with the use of fix walls that changes status (transparent/ reflective) by using gasses and /or liquids that flow inside the walls.

With this technology, the concentration can be achieved by using rotating equipment (like compressors, ventilators, pumps) that move a media (gas and/or liquid) to change the situation around the solar panel. In addition electricity can also be used to change the surface from transparent to reflective and vice versa.

The present invention wants to increase the performances of the photovoltaic and/or solar thermal plants, using a system of sun concentration with walls usually, but not necessarily, flats, on photovoltaic and/or solar thermal panels kept in fixed position.

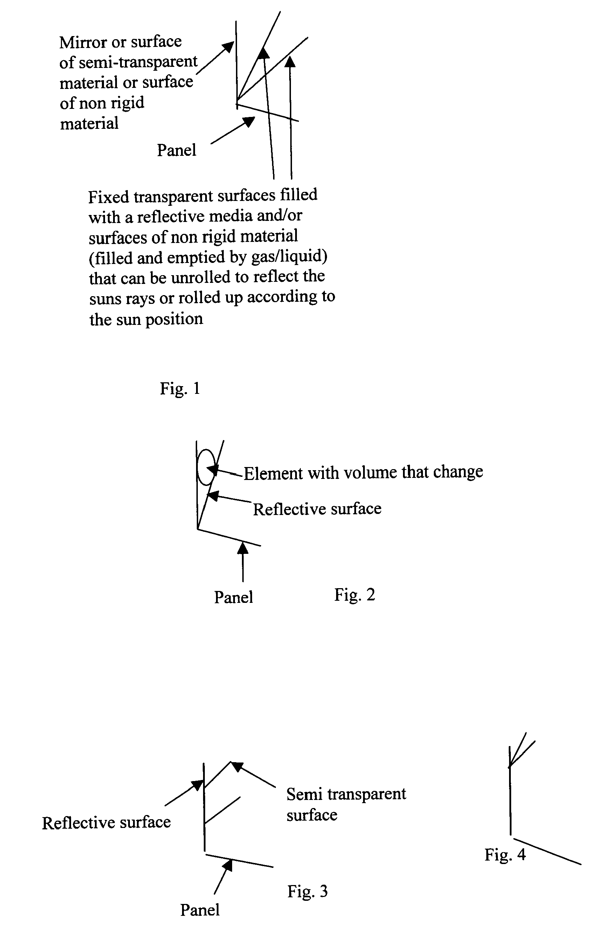

In detail, with reference to figure 1, the configuration considers the use of a fixed mirror to reflect the suns rays onto the panel, when the sun is high in the sky.

The transparent wall shown in figure 1 (i.e. glass with an internal chamber) allows the solar rays onto the mirror and thus reflected from the mirror, to pass through the transparent wall.

When the sun is less high in the horizontal, the transparent wall is filled with a reflective media (i.e. reflective liquid pumped inside the transparent wall, or reflective gas sent, by pressure, in the transparent wall).

In this case, the solar rays will arrive on the wall that previously was transparent, and will be reflected onto the photovoltaic and/or solar thermal panel.

It is also possible to use a different number of transparent pieces that can become mirrors based on the position of the sun, making a solution similar to a "fan". In addition, the mirror placed in figure 1, behind the walls that change from reflective to non reflective, can be a transparent wall filled, when necessary, with a reflective media. So, in this last situation, a tank is not necessary to accumulate the reflective media, as the tank can be the transparent wall itself.

Finally, always with reference to figure 1, the transparent wall can also be substituted with a solid non rigid reflective material that can be un rolled up when the sun is high in the sky, and then unrolled (i.e. using gas and/or liquid sent in the internal part or any other solution that allows the movement of the wall), it becomes the reflective flat wall, when the sun decreases in elevation.

Also in this case, it is possible to consider a solution as a "fan", using different surfaces typically, but not necessarily, flats each one at a different angle.

The rigid mirror can also be substituted by a non rigid material that can be rolled up or unrolled according to the position of the sun.

Another configuration (fig. 2) is when the sun is high in the horizon and the piece with variable volume (i.e. Like a balloon filled by air or a piston) is empty, so the reflective surface is placed together with the fixed surface. When the sun decreases elevation in the sky, the element with changeable volume is filled by gas, taking the reflective surface to a new position. A system like this removes the need of the installation of rotating mechanical elements, as the movement is realized by an element that changes volume, with advantages, such as cost reduction on the materials.

The fix surface could also be fixed to the ground around the photovoltaic and/or solar panel. This configuration could be realized as follows:
- Using different rigid elements with volumes that change (like pistons) and/or a non rigid element that can be inflated or deflated, so that the rigid reflective surface could move to different angles with respect to the vertical line (in fig. 2 are specified 2 positions only, but the reflective surface could have many more); and/or
- Doing in such a way that the reflective surface could be an element filled by gas (like air) or liquid, with a certain number of separated chambers that can be inflated or deflated according to the position of the sun. In this way, also the wind loads, that with a rigid concentrator shall be supported from the structure, are minimised, as in case of wind, the element filled by gas will deform
   With reference to the figure 3, the semi transparent surface allows the transmission of the suns rays, when the suns rays are on the superior part of it, while when the suns rays arrive on the other side, reflective side; they are reflected onto the photovoltaic panel. When the sun has a "low" position in the horizontal (sky) (usually during sunrise/sunset), the suns rays arrives on the other side of the semi transparent surface, that, in this case, reflect the suns rays onto the mirror, and then to the photovoltaic panel.

In this way, it is possible to concentrate the suns rays on the photovoltaic panel, also when the sun is low in the sky.

In the figure 1 it is possible to change, according to the conditions, the angles between the different surfaces.

Also the number of the different semi-reflective surfaces can change, and it is possible to use solutions similar of a "fan" (please refer to figure 4, for reference).

For the solar thermal panels the same result can be obtained using only the reflective wall, without using any semi-reflective material.

## Claims

1. Use of fixed walls, transparent and/or reflective, of any material that changes according to the position of the sun

2. Use of gasses and/or liquids and/or solids and/or electric energy to reflect the suns rays, to modify a surface initially transparent

3. To use special material that can reflect the suns rays on one side and transparent if the suns rays arrives on the other side

4. To use machinery (i.e. compressors and/or ventilators and/or pumps) to change the property of the surfaces (from transparent to reflective, and vice versa)

5. Movement in steps of the reflective surface

6. The reflective surface (rigid or non rigid) is moved by a gas or fluid, that act on the surface by variable volumes (i.e. solid parts, that contain gasses or liquids, like pistons or elements of non rigid material)

7. Sun concentration using non rigid surfaces

8. Sun concentration using reflective surfaces that, if they are filled by gas or liquid, increase in volume and they become reflective, vice versa, if they are emptied, they close, they do not interfere with the suns rays, and do not reflect the suns rays.

9. Combined or separated use of 1 or more solutions specified in points from 1 to 8, on any side/sides of the photovoltaic and/or solar thermal panels

10. Sun concentration with a fixed reflective surface for solar thermal panels, only.
